(19) Europäisches Patentamt
European Patent Office
Office européen des brevets

(11) **EP 1 780 889 B1**

## (12) EUROPÄISCHE PATENTSCHRIFT

(45) Veröffentlichungstag und Bekanntmachung des Hinweises auf die Patenterteilung:
**22.07.2009 Patentblatt 2009/30**

(21) Anmeldenummer: **06020030.0**

(22) Anmeldetag: **25.09.2006**

(51) Int Cl.:
***H03H 7/46*** *(2006.01)*

(54) **Schaltbare Frequenzweiche für Mikrowellen- und Hochfrequenzanwendungen**

Switchable diplexer for microwave and high frequency applications

Diplexeur commutable pour applications micro-ondes et haute fréquence

(84) Benannte Vertragsstaaten:
**DE FR GB**

(30) Priorität: **21.10.2005 DE 102005050630**

(43) Veröffentlichungstag der Anmeldung:
**02.05.2007 Patentblatt 2007/18**

(73) Patentinhaber: **Rohde & Schwarz GmbH & Co. KG**
**81671 München (DE)**

(72) Erfinder: **Richt, Bernhard**
**81827 München (DE)**

(74) Vertreter: **Körfer, Thomas et al**
**Mitscherlich & Partner**
**Patent- und Rechtsanwälte**
**Postfach 33 06 09**
**80066 München (DE)**

(56) Entgegenhaltungen:
**GB-A- 2 210 749          US-A1- 2003 022 631**

• **METHOT F: "CONSTANT IMPEDANCE BANDPASS AND DIPLEXER FILTERS" RF DESIGN, Bd. 9, Nr. 11, November 1986 (1986-11), Seiten 92,94,96-97,99, XP001086415 ISSN: 0163-321X**
• **ALPHA INDUSTRIES, INC: "Design with PIN Diodes" APPLICATION NOTE (APN1002), Juni 1999 (1999-06), Seiten 1-18, XP002419444**

**Beschreibung**

Die vorliegende Erfindung betrifft eine schaltbare Frequenzweiche für Mikrowellen- und Hochfrequenzanwendungen.

Im Hochfrequenzbereich werden nicht schaltbare Frequenzweichen (Diplexer), bestehend aus einem Hochpasszweig und einem Tiefpasszweig, üblicherweise so dimensioniert, daß sich an einer für den Hochpass- und den Tiefpasszweig identischen Weichenübernahmefrequenz fw eine Dämpfung von S21=-3dB ergibt. Die Leistung teilt sich bei dieser Frequenz auf beide Zweige zu gleichen Teilen auf.

Die Tiefpassgrenzfrequenz fgtp, bis zu der ein gewünschter maximaler Reflexionsfaktor am Tiefpassausgang und am gemeinsamen Tor eingehalten werden kann, ist kleiner als fw und hängt wie die Dämpfung im Sperrbereich von der Elementezahl und der Dimensionierung des Tiefpasses ab. Gleiches gilt sinngemäß für den Hochpasszweig. Damit ist

$$fgtp < fw < fghp.$$

Zwischen fgtp und fghp existiert also eine Lücke im Frequenzbereich, die nicht mit den geforderten Eigenschaften genutzt werden kann.

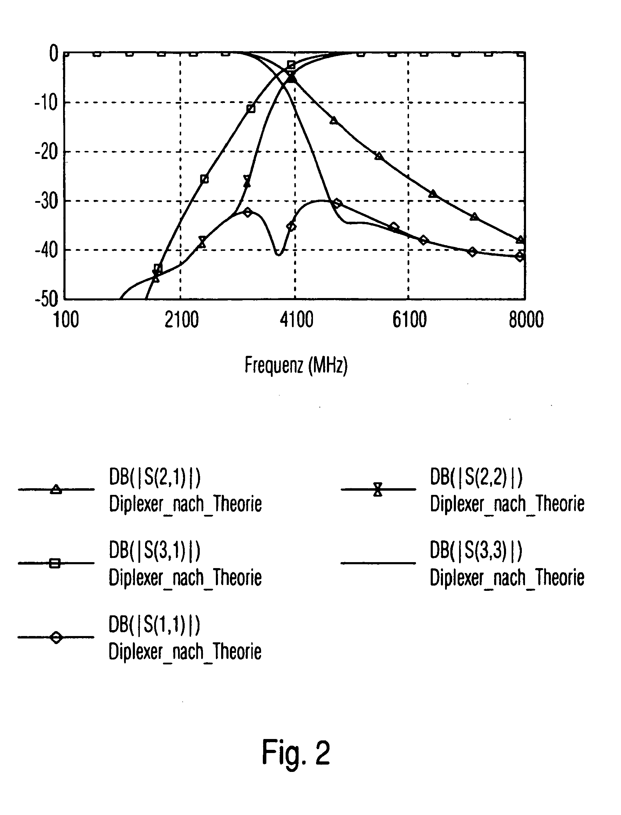

Diesen Sachverhalt soll folgendes Beispiel verdeutlichen. Es wird eine Weiche erläutert mit den Dimensionierungswerten n=5, Zo=50 Ohm, r=5%, fgtp=3 GHz, fstp=5,2 GHz, und astp=20 dB, woraus fw=3,85 GHz und fghp=4,86 GHz folgt. Dabei gibt fgtp die Tiefpassgrenzfrequenz und fstp die Sperrfrequenz des Tiefpasses an, bei der der Frequenzgang einen Wert von astp=-20 dB aufweist. fw gibt die Weichenfrequenz an und fghp die Grenzfrequenz des Hochpasses. In Fig. 2 sind die Ergebnisse gezeigt.

Fig. 2 lässt sich entnehmen, dass der Abfall des Tiefpass-Frequenzganges etwa 20dB pro Dekade beträgt, der Abfall des Hochpass-Frequenzganges etwa 40dB pro Dekade beträgt und bei der Weichenübernahmefrequenz eine Dämpfung von - 3dB erfolgt. An der Weichenübernahmefrequenz schneiden sich die Frequenzgänge und besitzen damit die gleiche Dämpfung.

Ein Nachteil dieser Weiche beim Betrieb bis zur Weichenübernahmefrequenz fw ist, dass bei fw eine Dämpfung von S21=-3dB in Kauf genommen werden muss und der gewünschte Reflexionsfaktor nicht an allen Toren eingehalten werden kann.

Beim generellen Aufbau einer Weiche besteht zusätzlich die Bedingung, dass prinzipiell der Hochpasszweig wie auch der Tiefpasszweig am gemeinsamen Tor immer mit einem Längselement L oder C beginnen muß, weil anderenfalls durch das ersten Element des Zweiges der andere Zweig in dessen Übertragungsfrequenzbereich kurzgeschlossen werden würde.

Um den oben genannten Nachteil zu umgehen, werden schaltbare Frequenzweichen (Diplexer) eingesetzt. Üblicherweise werden dabei die Weichenelemente zunächst für zwei unterschiedliche Weichen mit den Weichenübernahmefrequenzen fw1 und fw2 dimensioniert, wobei gelten soll

$$fw1 = fghp1 < fw2 = fgtp1$$

Somit wird erreicht, daß im eingeschalteten Zustand des Tiefpasses die Weichenübernahmefrequenz fw2 und im ausgeschalteten Zustand des Tiefpasses die Weichenübernahmefrequenz fw1 eingestellt wird. Es ergeben sich dadurch überlappende Frequenzbereiche, eine geringere Durchgangsdämpfung und eine bessere Anpassung bei der Weichenübernahmefrequenz fw.

Für die üblicherweise nicht geschalteten Längselemente der Weiche wird ein Kompromiß zwischen den eigentlich erforderlichen Dimensionierungen für fw1 und fw2 angestrebt. Ein Umschalten dieser Längselemente würde einen wesentlich höheren Schaltungsaufwand erfordern als ein Umschalten von Querelementen.

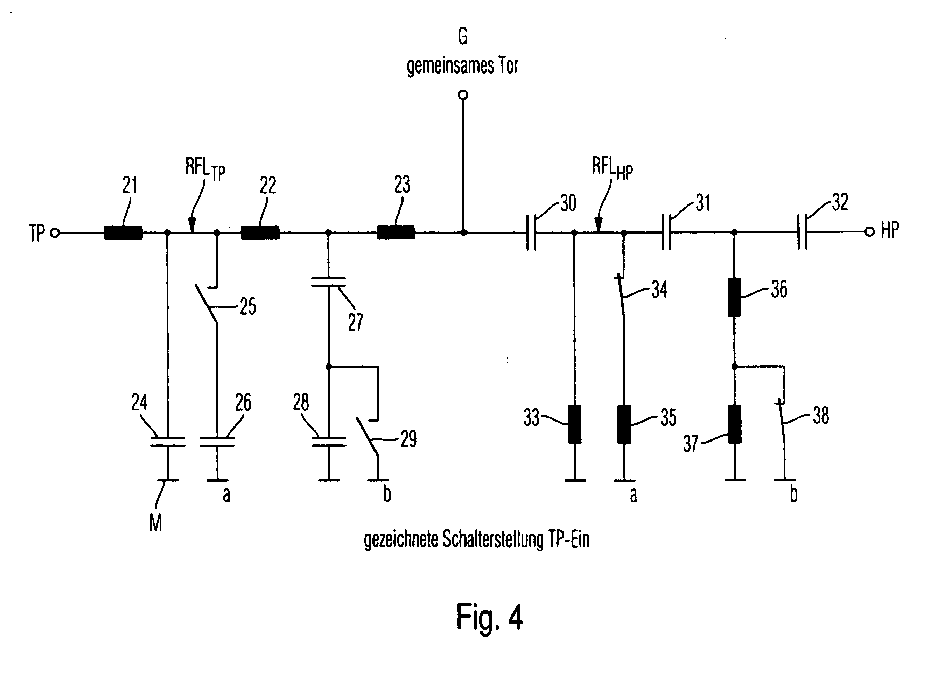

Es wird versucht, die Querelemente der Hoch- und Tiefpässe durch Serienschaltung oder Parallelschaltung von weiteren Bauteilen, wie in Fig. 4 gezeigt, durch Schaltelemente wie PIN- Dioden oder FET-Schalter für die beiden Betriebszustände der Weiche zu dimensionieren.

Diese Vorgehensweise hat den Nachteil, daß unvermeidliche nichtideale Eigenschaften der Schaltelemente, wie z.B. die Serieninduktivität im eingeschalteten Zustand oder die Sperrkapazität im ausgeschalteten Zustand, die Eigenschaften der Frequenzweiche verschlechtern und die Dimensionierung der geschalteten Weiche schwierig oder sogar unmöglich machen. Bei dem o.g. Beispiel mit fw = 3GHz haben diese parasitären Elementewerte üblicher technischer Bauteile die gleiche Größenordnung wie die Werte der echten Elemente.

Aus dem Artikel von F. Methot "Constant Impedance Bandpass and Diplexer Filters" der Fachzeitschrift "rf design feature", November 1986, (Seiten 92, 94, 96, 97 und 99) ist eine Frequenzweiche für ein Hochfrequenzsignal bekannt mit einem Tiefpass-Pfad und einem Hochpass-Pfad mit Längselementen und Querelementen in jeweils einer Hochfrequenz-Leitung. Ein Hochfrequenzsignal wird an den Eingang, über einen Widerstand mit Wert 75 Ω eingespeist. Das Signal wird über den Hochpassteil und den Tiefpassteil transferiert und gefiltert. Das Ergebnis der Filterungen lässt sich an den 75 Ω Widerständen am Ausgang des Hochpass-Pfades und am Ausgang des Tiefpass-Pfades abgreifen.

Aus der GB-A-2 210 749 geht ein schaltbares Tiefpass-Filter für ein Hochfrequenz-Signal hervor mit einer Hochfrequenz-Leitung, gebildet entlang der Serienschaltung der Induktivitäten zwischen dem Innenwiderstand der Signalquelle und dem oberen Anschluss des Empfängerwiderstandes mit Längselementen, welche Induktivitäten darstellen, und Querelementen. Die Dioden werden über 4k-Widerstände mit einer Spannung +5V über einen Schalter und -2V über einen 10k-Widerstand angesteuert. Damit kann das Übertragungsband des Filters von einer oberen Frequenz auf eine niedrigere Frequenz verringert werden.

Alpha Industries, Inc.: "Design with PIN Diodes", Juni 1999, Seiten 1-18, offenbart Grundlagen, Ersatzschaltungen und Anwendungen von PIN-Dioden. PIN-Dioden können als stromgesteuerter Widerstand im durchgeschalteten Zustand angesehen werden und als Kapazität im gesperrten Zustand. Die elektrischen Modelle weisen im Falle des Vorwärtsmodells ("Forward Bias Model") zusätzlich noch eine Bauteilinduktivität auf. Ein Kontaktwiderstand und der Widerstand des Diodengehäuses limitieren den einstellbaren Widerstand nach unten hin. Im Falle des Rückwärtsmodells ("Reverse Bias Model") liegt ein Widerstand parallel zur Kapazität vor. Dieser ist proportional zur angelegten Spannung und umgekehrt proportional zur Frequenz des angelegten Signals.

Die Offenlegungsschrift US 2003/0022631A1 beschreibt ein schaltbares Tiefpass-Filter, wobei Induktivitäten in Serie zwischen einem ersten Signal-Eingang und einem dritten Signal-Eingang geschalten sind. Zwischen den Induktivitäten sind Kapazitäten nach Masse geschalten, die damit Einpolfilterelemente bilden. Darüber hinaus weist der Filter einen Notchfilterteil auf mit Induktivitäten, Kapazitäten sowie Dioden. Der Notchfilterteil kann durch die Dioden zugeschaltet werden. Die Steuer-Spannung wird von einem Mikroprozessor geliefert.

Die Aufgabe der Erfindung liegt somit darin, eine umschaltbare Frequenzweiche mit sich überlappenden Frequenzbereichen zu realisieren, bei der sich die nichtidealen Eigenschaften der Schaltelemente, wie z.B. die Serieninduktivität im eingeschalteten Zustand oder die Sperrkapazität im ausgeschalteten Zustand, nicht negativ auf die Eigenschaften und die Dimensionierung der Frequenzweiche auswirken.

Die Aufgabe wird durch die Merkmale des Anspruches 1 gelöst. Vorteilhafte Weiterbildungen sind in den Unteransprüchen angegeben.

Die vorliegende Erfindung realisiert eine Frequenzweiche mit einem Tiefpass-Pfad und einem Hochpass-Pfad mit Querelementen und Längselementen, wobei die Schaltelemente sowohl im Hochpass- als auch im Tiefpass-Pfad jeweils an den Stellen der Querelemente direkt von der RF-Leitung nach Masse geschaltet sind.

Es befinden sich bei aktivem Hochpass-Pfad die Schaltelemente des Hochpass- und Tiefpass-Pfades im durchgeschalteten Zustand.

Es befinden sich bei aktivem Tiefpass-Pfad die Schaltelemente des Hoch- und Tiefpass-Pfades ausschließlich im gesperrten Zustand.

Vorzugsweise wird die parasitäre Parallel-Kapazität bei Schaltelementen im gesperrten Zustand als Tiefpassquerelement verwendet.

Vorzugsweise wird die im gesperrten Zustand der Schaltelemente als Tiefpassquerelement verwendete parasitäre Parallel-Kapazität durch eine dem Schalter parallel geschaltete Kapazität ergänzt.

Vorzugsweise wird die parasitäre Serien-Induktivität der Schaltelemente im durchgeschalteten Zustand als Hochpass-Querelement verwendet.

Vorzugsweise wird die im durchgeschalteten Zustand der Schaltelemente als Hochpass-Querelement verwendete parasitäre Serien-Induktivität durch eine dem Schaltelement in Serie geschaltete Induktivität ergänzt.

Vorzugsweise werden als Schaltelemente zur Schaltung des aktiven Tiefpass-Pfades PIN-Dioden im gesperrten Zustand verwendet.

Vorzugsweise werden als Schaltelemente zur Schaltung des aktiven Hochpass-Pfades PIN-Dioden in Flußrichtung gepolt verwendet.

Vorzugsweise sind bei Verwendung von PIN-Dioden als Schaltelemente diese pro Schaltelement für den Steuerstrom in Serie geschaltet, für das RF-Signal jedoch unter Verwendung eines Abblockkondensators parallel geschaltet.

Vorzugsweise sind für die Zufuhr der PIN-Dioden-Steuerströme keine zusätzlichen Abblock-Induktivitäten am RF-Pfad des Hoch- oder Tiefpasses erforderlich.

Vorzugsweise liegt der Steuerstrom, der über den PIN-Diodenanschluss zugeführt wird, für die RF-Frequenzen über einen Abblockkondensator auf Masse.

Vorzugsweise wird über einen hochohmigen Widerstand eine Sperrspannung Usperr an die Dioden, d.h. an die RF-Leitung, gelegt.

Alternativ wird der Steuerstrom der PIN-Dioden über ein Leitungspaar U1 und U2 zugeführt. Dazu werden alle PIN-Dioden über Abblockkondensatoren nach Masse geschaltet. Die hochohmigen Widerstände an der RF-Leitung werden nach Masse geschaltet und sorgen so für ein Gleichspannungspotential von 0 Volt an der RF-Signal-Leitung. Die Sperrspannung der Dioden wird über U1 und U2 angelegt.

Nachfolgend werden Ausführungsbeispiele der Erfindung unter Bezugnahme auf die Zeichnung beschrieben. In der die Zeichnung zeigen:

Fig. 1    die Dimensionierung einer ideale Weiche;

Fig. 2    die S-Parameter einer ideale Weiche;

Fig. 3    erfindungsgemäße Schalteranordnung bei einer erfindungsgemäßen schaltbaren Weiche;

Fig. 4    eine übliche schaltbare Weiche mit idealen Schaltelementen;

Fig. 5    eine erfindungsgemäße schaltbare Weiche mit Schaltelementen und parasitären Elementen der Schaltelemente;

Fig. 6 eine erfindungsgemäße schaltbare Weiche mit PIN-Dioden als Schaltelemente;

Fig. 7 eine erfindungsgemäße schaltbare Weiche mit PIN-Dioden als Schaltelemente im symmetrischen Aufbau und

Fig. 8 das Simulationsergebnis einer schaltbaren Weiche nach Fig. 7.

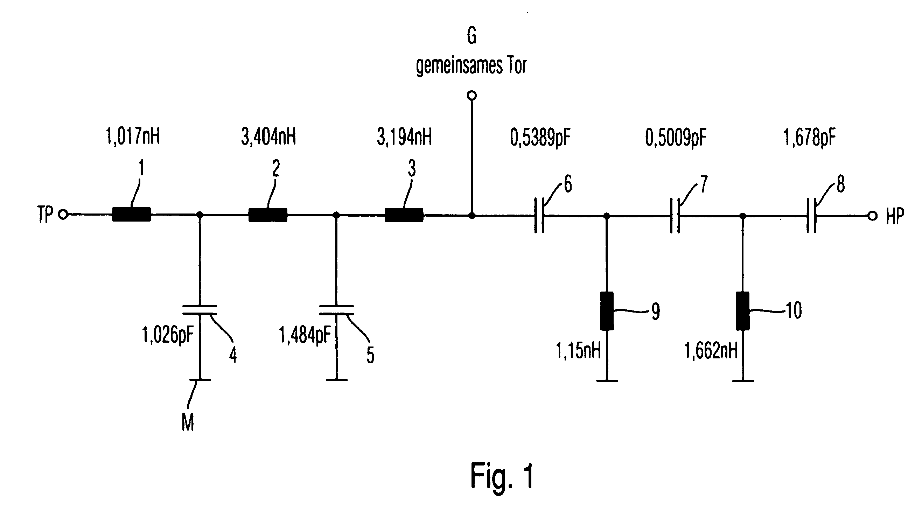

Fig. 1 zeigt eine ideale Weiche 5. Ordnung. Die Ordnung bezieht sich dabei auf die Ordnung des Tiefpass- und Hochpass-Pfades, welche in diesem Falle die gleiche Ordnung besitzen. Eine Ordnung von 5 gibt an, wieviele Energiespeicher in einem Zweig der Weiche, Tiefpaß oder Hochpaß, vorhanden sind. Energiespeicher sind dabei entweder Induktivitäten oder Kapazitäten. Der Tiefpaß besteht in diesem Falle aus drei Induktivitäten 1, 2 und 3 sowie zwei Kapazitäten 4 und 5. Der Hochpaß besteht aus drei Kapazitäten im Längspfad 6, 7 und 8 sowie zwei Induktivitäten in Querpfaden 9 und 10.

Soll ein Signal tiefpass- bzw. hochpassgefiltert werden, so wird dieses an den Anschluß angelegt, welcher in Fig. 1 mit 'gemeinsames Tor' gekennzeichnet ist. Das tief- bzw. hochpassgefilterte Signal kann dann an den Anschlüssen 'TP' bzw. 'HP' abgegriffen werden.

Ein Beispiel einer Dimensionierung ist in Fig. 1 angegeben. Die Werte für die Bauteile wurden so gewählt, daß das Bauelement 1 den Wert 1,017nH, das Bauelement 2 den Wert 3,404nH, das Bauelement 3 den Wert 3,194nH, das Bauelement 4 den Wert 1,026pF, das Bauelement 5 den Wert 1,484pF erhält. Hochpassseitig erhalten die Bauelemente die Werte 0,5389pF für das Bauelement 6, 0,5009pF für das Bauelement 7, 1,678pF für das Bauelement 8, 1,15nH für das Bauelement 9 und 1,662nH für das Bauelement 10. Damit ergeben sich die Beträge der S-Parameter der idealen Weiche wie sie in Fig. 2 gezeigt sind.

Dabei stellt die Kennlinie mit Dreiecken den S-Parameter S21, die Kennlinie mit Quadraten den S-Parameter S31, die Kennlinie mit Diamanten den S-Parameter S11, die Kennlinie mit Doppeldreiecken den S-Parameter S22 und die Kennlinie mit Querstrich den S-Parameter S33 dar. Bei der Messung des S-Parameters S21 wird die Messung zwischen den Anschlüssen G und TP durchgeführt, bei der Messung des S-Parameters S31 wird die Transmissions-Messung an den Anschlüssen G und HP durchgeführt und bei der Messung der S-Parameter S11, S22, S33 wird die Reflexions-Messung jeweils an den Anschlüssen G, TP, HP durchgeführt. Die jeweils freibleibenden Anschlüsse werden mit 50Ω-Abschlusswiderständen abgeschlossen. Der S-Parameter S21 gibt das Übertragungsverhalten des Dreitors über die Anschlüsse G und TP, also das Übertragungsverhalten des Tiefpasses an. Der S-Parameter S31 gibt das Übertragungsverhalten des Dreitors über die Anschlüsse G und HP, also das Übertragungsverhalten des Hochpasses an. Der S-Parameter S11 gibt das Reflexionsverhalten des Dreitors am Anschluss G an, wobei die Anschlüsse TP und HP durch 50Ω-Abschlusswiderstände abgeschlossen sind. Der S-Parameter S22 gibt das Reflexionsverhalten des Dreitors am Anschluss TP an, wobei die Anschlüsse G und HP durch 50Ω-Abschlusswiderstände abgeschlossen sind. Der S-Parameter S33 gibt das Reflexionsverhalten des Dreitors am Anschluss HP an, wobei die Anschlüsse G und TP durch 50Ω-Abschlusswiderstände abgeschlossen sind.

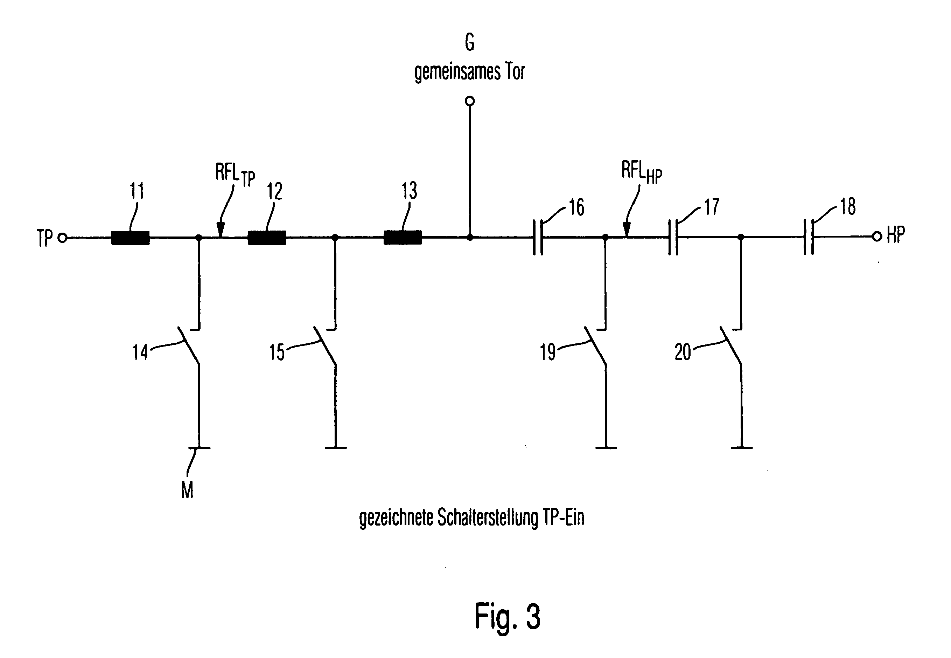

Fig. 3 zeigt eine schaltbare Weiche mit idealen Schaltelementen, bei denen die Knoten zwischen den Elementen 11, 12, 14; 12, 15, 13; 16, 19, 17; 17, 20, 18 jeweils über die Schalter 14, 15, 19, 20 nach Masse verbunden werden. In den Längspfaden befinden sich tiefpass-seitig die Induktivitäten 11, 12, 13, hochpassseitig die Kapazitäten 16, 17, 18. Diese Schaltung bildet die Grundschaltung für alle nachfolgenden Ausführungsbeispiele.

Fig. 4 zeigt Schalteranordnungen, welche bei einer üblichen schaltbaren Frequenzweiche verwendet werden. Im Tiefpass-Pfad, gekennzeichnet mit Anschluss 'TP', werden als Querelemente Kapazitäten 24, 26, 27, 28 verwendet. Dabei werden die Kapazitäten 24, 26 in Parallelschaltung und die Kapazitäten 27, 28 in Serienschaltung betrieben. In der in Fig. 4 dargestellten Schalterstellung a wird dabei in der Parallelschaltung der Kapazitäten 24, 26 die Kapazität 26 durch einen Schalter 25 von der Hochfrequenz-Leitung bei RFL$_{TP}$ Schalterstellung TP-EIN (eingeschalteter Tiefpass) getrennt. Damit wird die Gesamtkapazität am Knoten zwischen den Elementen 21, 22, 24, 25 nach Masse M halbiert.

In der anderen Schalterstellung b wird in der Serienschaltung der Kapazitäten 27, 28 die Kapazität 28 durch einen Schalter 29 in der Schalterstellung TP-AUS (ausgeschalteter Tiefpass) überbrückt und damit die Gesamtkapazität am Knoten zwischen den Elementen 22, 27, 23 nach Masse verdoppelt.

Analog wird bei der Verschaltung der Induktivitäten 33, 35, 36, 37 im Hochpass-Pfad verfahren. Dabei wird in der Schalterstellung Tiefpass-EIN (eingeschalteter Tiefpass) die Gesamtinduktivität 33, 35 durch Schließen des Schalters 34 halbiert. Analog zu Schalterstellung b im Tiefpass-Pfad wird die Induktivität am Knoten von der Hochfrequenz-Leitung RFL$_{HP}$ nach Masse durch Schließen des Schalters 38 und damit Überbrücken der Induktivität 37 halbiert.

Im Einzelnen ist die Schaltung nach Fig. 4 wie folgt aufgebaut:

Ein Knoten zwischen den Induktivitäten 21 und 22 ist über einen erster Kondensator 24 nach Masse M verbunden. Von diesem ersten Knoten ist ein Schalter 25 über einen Kondensator 26 ebenfalls nach Masse M verbunden. Der erste Anschluss der Induktivität 21 bildet den Ausgang der Tiefpassschaltung, welche aus den Induktivitäten 21, 22 und 23 sowie den Kapazitäten 24, 26, 27, 28 und den Schaltern 25 und 29 gebildet ist.

Mit einem zweiten Knoten zwischen den Induktivitäten 22 und 23 ist der erste Anschluss eines Kondensator 27 verbunden. Mit dem zweiten Anschluss des Kondensators 27 ist ein weiterer Kondensator 28 verbunden, der den Kondensator 27 nach Masse M verbindet. Der Kondensator 28 kann über einen Schalter 29 kurzgeschlossen werden.

Der Eingang G der Schaltung ist an einem Knoten zwischen der Induktivität 23 und der Kapazität 30 angebracht. Dieser verbindet die Bauelemente 21-29 des Tiefpassteils und die Bauelemente 30-38 des Hochpassteils der Frequenzweiche.

Von einem weiteren Knoten zwischen den Induktivitäten 30 und 31 ist eine Induktivität 33 nach Masse M verbunden. Ein weiterer Schalter 34 und eine weitere Induktivität 35 verbinden diesen Knoten nach Masse M, so dass die Induktivität 33 und die Serienschaltung aus Schalter 34 und Induktivität 35 eine Parallelschaltung bilden. Der zweite Anschluss der Kapazität 31 ist mit einem Anschluss der Kapazität 32 verbunden. Dieser Knoten ist über eine Serienschaltung der Induktivitäten 36 und 37 nach Masse M verbunden.

Der Knoten zwischen den Induktivitäten 36 und 37 ist über einen Schalter 38 nach Masse M verbunden. Dieser ist parallel zur Induktivität 37 geschaltet und schließt diese kurz. Der zweite Anschluss der Induktivität 32 bildet den Ausgang der Hochpassschaltung, welche aus den Kapazitäten 30, 31 und 32 sowie aus den Induktivitäten 33, 35, 36, 37 und den Schaltern 34 und 38 gebildet ist.

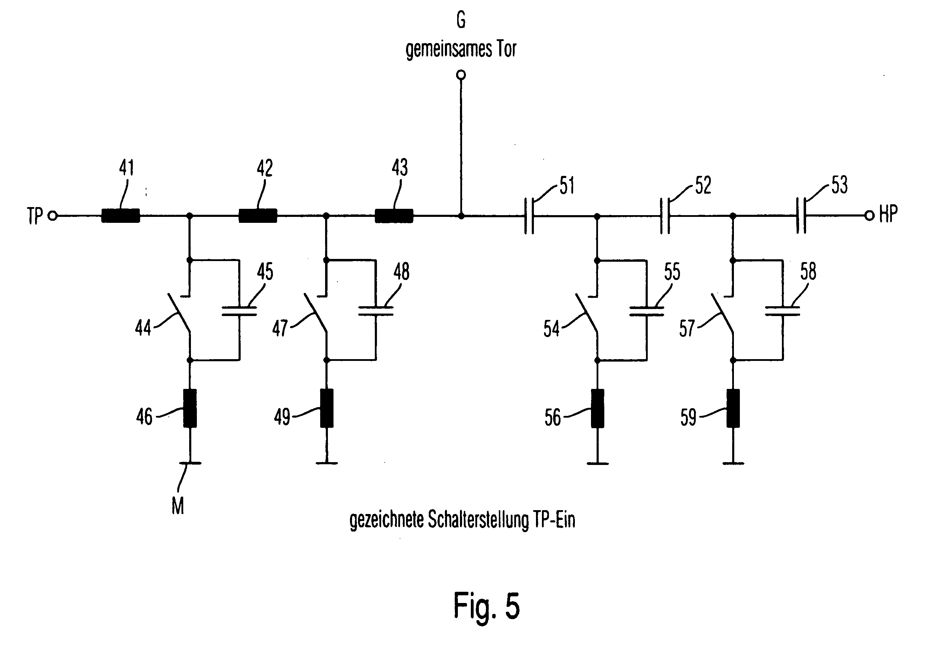

Fig. 5 zeigt eine erfindungsgemäße schaltbare Weiche mit realen Schaltelementen, bei denen die Knoten zwischen den Elementen 41, 44, 45, 42; 42, 47, 48, 43; 51, 54, 55, 52; 52, 57, 58, 53 zwischen Längselementen 41, 42, 43 und 51, 52, 53 jeweils über die Schalter 44, 47, 54, 57 nach Masse verbunden sind. In den Längspfaden befinden sich tiefpassseitig die Induktivitäten 41, 42, 43, hochpass-seitig die Kapazitäten 51, 52, 53. Jeder der realen Schalter 44, 45, 46; 47, 48, 49; 54, 55, 56 sowie 57, 58, 59 weist je eine parasitäre Induktivität 46, 49, 56, 59 und je eine parasitäre Kapazität 45, 48, 55, 58 auf. Die Elementwerte der parasitären induktiven sowie kapazitiven Schaltelementbeiwerte liegen für die betrachteten Frequenzbereiche in einem Bereich, für den diese als Dimensionierungsgrößen Berücksichtigung finden.

Im Einzelnen ist das Ersatzschaltbild der Frequenzweiche nach Fig. 5 wie folgt aufgebaut:

Der Tiefpassteil der Frequenzweiche wird aus den idealen Schaltern 44 und 47 sowie aus den Induktivitäten 41, 42, 43, 46, 49 und den Kapazitäten 45 und 48 gebildet. Der Hochpassteil der Schaltung besteht aus den Kapazitäten 51, 52, 53, den Schaltern 54, 57 sowie den Induktivitäten 56 und 59. Der Eingang der Frequenzweiche befindet sich an einem dritten Knoten zwischen der Induktivität 43 und der Kapazität 51 und ist durch einen Eingang G ausgezeichnet. Damit besteht die Frequenzweiche aus den Induktivitäten 41, 42, 43, 46, 49, 56, 59, den Schaltern 44, 47, 54, 57 sowie den Kapazitäten 45, 48, 51, 52, 53, 55, 58. Der Ausgang TP des Tiefpassteils ist an einem ersten Anschluss der Induktivität 41 angebracht. Der Ausgang HP des Hochpassteils der Frequenzweiche ist an einem zweiten Anschluss der Kapazität 53 angebracht.

Mit einem Knoten zwischen den Induktivitäten 41 und 42 ist der erste Anschluss einer Parallelschaltung aus einem idealen Schalter 44 und der parasitären Kapazität 45 verbunden. Von einem zweiten Anschluss dieser Parallelschaltung aus idealem Schalter 44 und der Kapazität 45 verbindet eine Induktivität 46 diesen Anschluss nach Masse M. An einem weiteren Knoten zwischen den Induktivitäten 42 und 43 des Tiefpassteils der Frequenzweiche ist eine weitere Parallelschaltung aus einem idealen Schalter 47 und einer parasitären Kapazität 48 mit einem ersten Anschluss geschaltet. Der ideale Schalter 47 schließt die parasitäre Kapazität 48 kurz. Mit einem zweiten Anschluss der Parallelschaltung aus idealem Schalter 47 und parasitärer Kapazität 48 ist eine Induktivität 49 verbunden, welche den zweiten Anschluss der Parallelschaltung nach Masse M verbindet.

An einem Knoten zwischen der Kapazität 51 und 52 ist mit einem ersten Anschluss ein idealer Schalter 54 angeschlossen, der in Serie mit einem zweiten Anschluss mit der Induktivität 56 verbunden ist, welche den zweiten Anschluss des idealen Schalters 56 nach Masse M verbindet. In Parallelschaltung zu dem idealen Schalter 54, der zusammen mit den parasitären Elementen 55 und 56 den realen Schalter 54, 55, 56 simuliert, ist eine parasitäre Kapazität 55 geschaltet, welche bei geöffnetem Schalter 54 die kapazitiven Eigenschaften des realen Schalters 54, 55, 56 nachbildet.

Ein weiterer realer Schalter bestehend aus den Elementen 57, 58 und 59 verbindet den fünften Knoten zwischen den Kapazitäten 52 und 53 nach Masse M. Dabei ist das Element 57 ein idealer Schalter, das Element 58 eine parasitäre Kapazität und das Element 59 eine Induktivität, welche den parasitären induktiven Charakter des realen Schalters 57, 58, 59 nachbildet. Ein Anschluss des idealen Schalters 57 ist mit dem Knoten zwischen den Kapazitäten 52 und 53 verbunden. Parallel dazu befindet sich die Kapazität 58. An dem zweiten Anschluss der Parallelschaltung, an dem die zweiten Anschlüsse der idealen Element 57 und 58 zusammengeführt sind, ist eine Induktivität 59 angeschlossen, welche den zweiten Anschluss der Parallelschaltung 57, 58 nach Masse M verbindet. An einem zweiten Anschluss der Kapazität 53 ist der Ausgang HP des Hochpassteils angebracht.

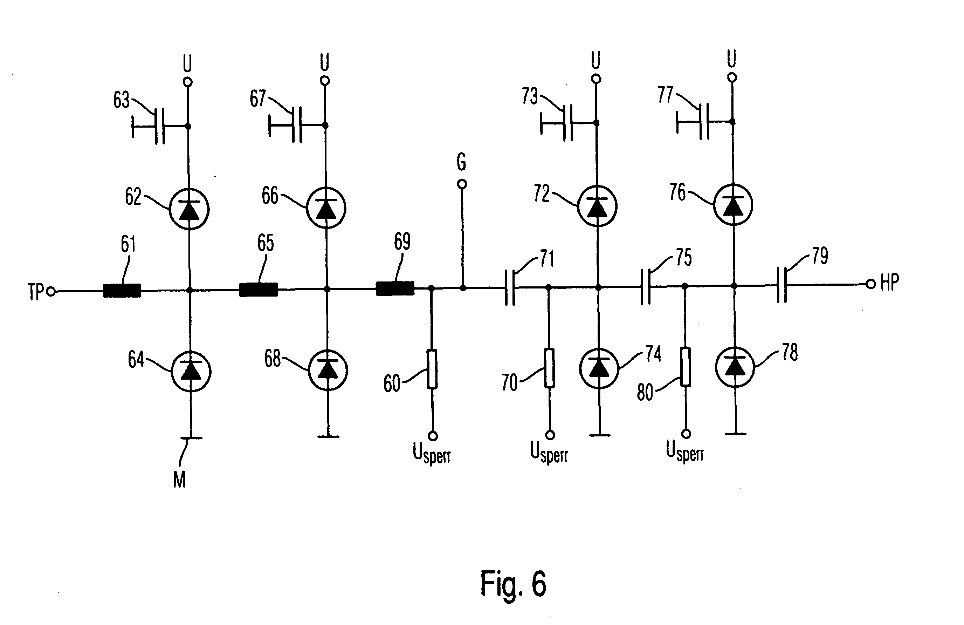

Fig. 6 zeigt eine weitere Realisierung der erfindungsgemäßen schaltbaren Frequenzweiche mit Hilfe von PIN-Dioden. Dabei sind diese in Reihe über den RF-Pfad 61, 65, 69 bzw. 71, 75, 79 zwischen Masse M und einer schaltbaren Spannung U geschaltet. Diese liefert den Schaltstrom. Bezüglich des Hochfrequenz-Signals sind diese PIN-Dioden parallel nach Masse M geführt. Pro Diodenpfad 64, 62, 63; 68, 66, 67; 74, 72, 73; 78, 76, 77 liegen jeweils zwei PIN-Dioden 64, 62; 68, 66; 74, 72; 78, 76 und jeweils eine Kapazität 63, 67, 73, 77 vor. Die Dioden 62, 64; 68, 66; 74, 72; 78, 76 sind in Flußrichtung von Masse zum Anschluß U geführt. Für das Hochfrequenz-Signal bilden die Kapazitäten 63, 67, 73, 77 Kurzschlüsse nach Masse. Durch Anlegen einer negativen Spannung an den Anschluß U sind die Dioden in Flussrichtung gepolt. Durch Anlegen einer Spannung Usperr an den RF-Pfad kann jeweils eine Diode 64, 68, 72, 76 der PIN-Dioden-Paare 64, 62; 68, 66; 74, 72; 78, 76 gesperrt werden. Dabei wird üblicherweise Usperr = U / 2 gewählt. Damit ist die Schalteigenschaften der Weiche nach Fig. 5 realisiert.

Im Einzelnen ist die Schaltung nach Fig. 6 wie folgt aufgebaut:

An einem Knoten zwischen den Induktivitäten 61 und 65 ist eine PIN-Diode 64 mit ihrem ersten Anschluss geschaltet. Mit einem zweiten Anschluss ist diese Diode mit Masse M verbunden. Die Diode verbindet die Masse M zu dem Knoten zwischen der Induktivität 61 und 65, so dass diese in Gegenflussrichtung den Knoten von der Masse M trennt. Von dem selben Knoten zwischen den Induktivitäten 61 und 65 führt eine weitere Diode 62 in Flussrichtung zu einem Anschluss U. Dieser Anschluss ist über eine Kapazität 63 mit Masse M verbunden.

Zwischen den Induktivitäten 65 und 69 befindet sich ein zweiter Knoten, an dem die Diode 68 mit einem zweiten Anschluss angeschlossen ist. Mit ihrem ersten Anschluss ist diese Diode mit Masse M verbunden. Des weiteren ist eine zweite Diode 66 mit einem ersten Anschluss an den Knoten zwischen den Induktivitäten 65 und 69 angeschlossen. Der zweite Anschluss der Diode ist mit einem Anschluss U verbunden. Von diesem Anschluss ist eine Kapazität 67 nach Masse M verbunden.

An einen Knoten zwischen der Induktivität 69 und der Kapazität 71 ist ein Widerstand 60 geschaltet, der diesen Knoten an einen Anschluss Usperr führt. Des weiteren ist an diesen Knoten der Eingang G der Frequenzweiche angeschlossen. An einen weiteren Knoten zwischen den Kapazitäten 71 und 75 ist eine PIN-Diode 74 geschaltet, welche diesen Knoten in Flussrichtung mit der Masse M verbindet. Ein erster Anschluss einer weiteren Diode 72 ist an den Knoten zwischen den Kapazitäten 71 und 75 angeschlossen. Ein zweiter Anschluss der Diode 72 verbindet den Knoten in Flussrichtung mit dem Anschluss U und ein Widerstand 70 verbindet den Knoten zu einem Anschluss Usperr. Von dem Anschluss U führt eine Kapazität 73 nach Masse M. Die Dioden 62, 66, 72, wie auch die im folgenden beschriebene Diode 76 sind jeweils über den Anschluss U ansteuerbar.

Ein Knoten zwischen den Kapazitäten 75 und 79 ist über einen Widerstand 80 mit einem Anschluss Usperr verbunden. Von diesem Knoten führt eine Diode nach Masse M, welche mit ihrem ersten Anschluss mit Masse M verbunden ist und mit einem zweiten Anschluss mit dem Knoten verbunden ist, so dass diese von Masse M zu diesem Knoten in Flussrichtung geschaltet ist. Mit diesen Knoten ist eine weitere Diode 76 mit ihrem ersten Anschluss verbunden und führt an einen Anschluss U über welchen die Diode 76 in Flussrichtung durchgeschaltet oder gesperrt werden kann. Der Knoten ist über die Kapazität 79 mit dem Ausgang HP des Hochpassteils der Frequenzweiche verbunden.

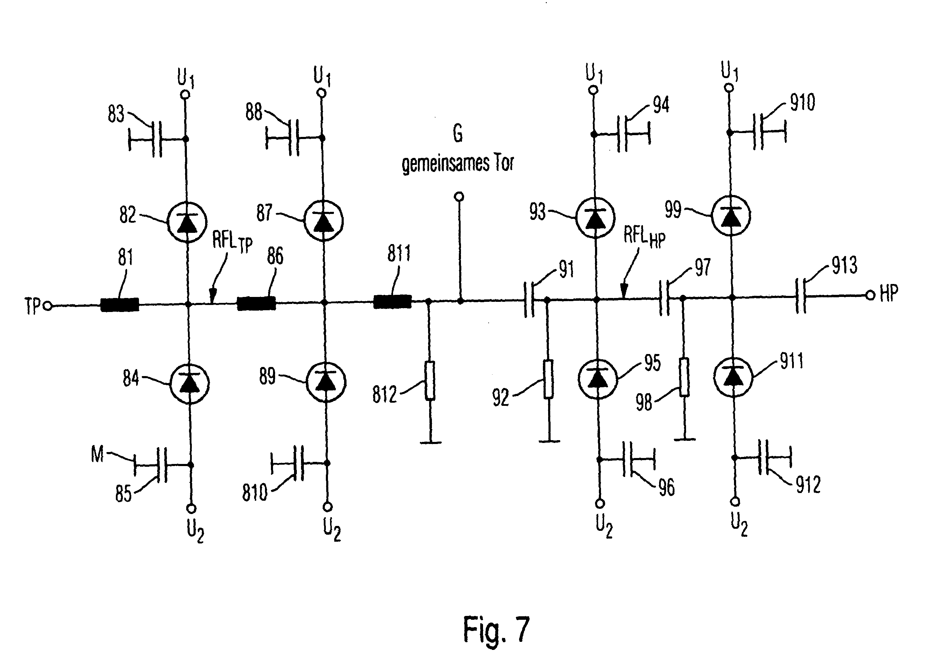

Fig. 7 zeigt eine erfindungsgemäße schaltbare Frequenzweiche in einer alternativen Realisierungsform. Der RF-Pfad wird durch die Elemente 81, 86, 811 bzw. 91, 97, 913 gebildet. Die Schaltung des Tief- bzw. Hochpasses erfolgt über die Schalter 85, 84, 82, 83; 810, 89, 87, 88; 96, 95, 93, 94; 912, 911, 99, 910. Dabei werden die Schalter aus jeweils zwei Kapazitäten 85, 83; 810, 88; 96, 94; 912, 910 und jeweils zwei PIN-Dioden 84, 82; 89, 87; 95, 93; 911, 99 gebildet. Diese sind in Flußrichtung von Anschluß U2 nach U1 über den RF-Pfad 81, 86, 811; 91, 97, 913 geführt.

Im Einzelnen ist die Schaltung nach Fig. 7 wie folgt aufgebaut:

An einen Knoten zwischen einer Induktivität 81 und einer Induktivität 86 ist eine PIN-Diode 84 geschaltet, welche ansteuerbar mit dem Anschluss U2 verbunden ist. Der Anschluss U2 ist über die Kapazität 85 mit Masse M verbunden. Von dem Knoten führt eine weitere PIN-Diode zu einem zweiten Anschluss U1, welcher ebenfalls über eine Kapazität 83 nach Masse M verbunden ist.

Von einem weiteren Knoten führt wiederum ein PIN-Diode 89 zu einem Anschluss U2, der über die Kapazität 810 nach Masse M verbunden ist. Der Knoten ist über die PIN-Diode 87 zu einem Anschluss U1 verbunden. Der Kondensator 88 verbindet den Knoten U1 nach Masse M und stellt für hochfrequente Signale eine Masseverbindung dar.

Die Induktivität 811 und die Kapazität 91 sind mit jeweils einem ihrer Anschlüsse verbunden. Dieser Knoten ist über den Widerstand 812 mit Masse M verbunden und bildet den Eingangsanschluss G der Gesamtschaltung. Der Knoten zwischen den Kapazitäten 91 und 97 ist zum einen über einen Widerstand 92 und zum anderen über die Diode 95 und Kondensator 96 nach Masse M verbunden. An dem Knoten zwischen der Diode 95 und dem Kondensator 96 ist ein Anschluss U2 angebracht über den die Diode 95 ansteuerbar ist.

Von dem Knoten zwischen der Kapazität 91 und der Kapazität 97 führt eine Diode 93 zu einem Anschluss U1, welche die Ansteuerung der Diode 93 erlaubt und über einen Kondensator 94 nach Masse M verbunden ist, der den Anschluß U1 für Hochfrequenzsignale nach Masse M verbindet.

Ein Knoten zwischen den Kapazitäten 97 und 913 ist über die PIN-Diode 911 in Gegenflussrichtung mit einem Anschluss U2 verbunden. Dieser Anschluss ist über den Entkopplungskondensator 912 mit Masse M verbunden. Von dem selben Knoten führt eine weitere Diode 99 zum Anschluss U1 und ein Kondensator 910 entkoppelt diesen Anschluss von Masse bezüglich einem Gleichspannungspotential, welches an diesem Anschluss angeschlossen werden kann. Über eine Kapazität 913 ist dieser Knoten mit dem Hochpassausgang der Gesamtschaltung verbunden.

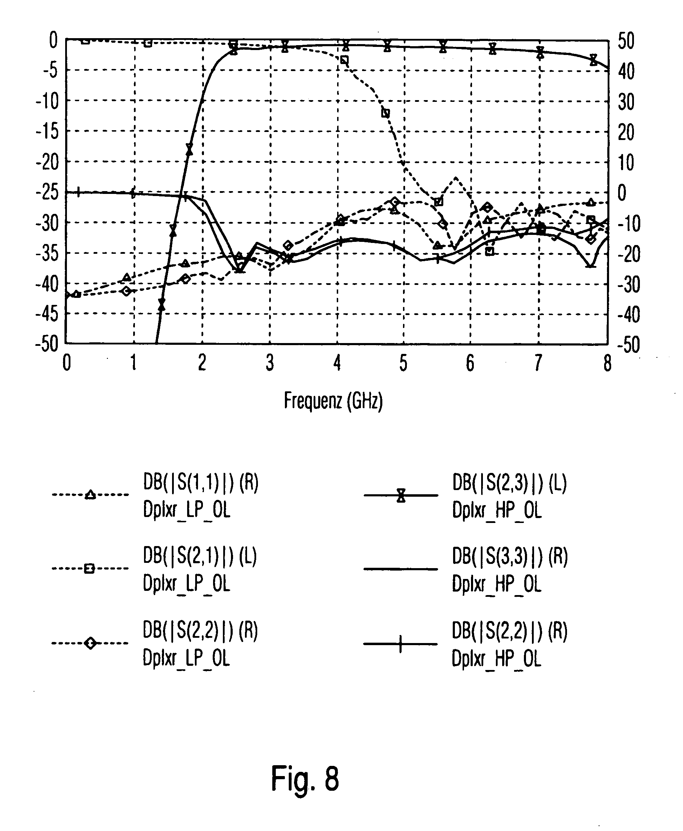

Fig. 8 zeigt die simulierten S-Parameter der erfindungsgemäßen Frequenzweiche nach Fig. 7. Bezüglich den dargestellten S-Parameter wird auf die Erläuterung zu Fig. 2 verwiesen.

Die Erfindung ist nicht auf die dargestellten Ausführungsbeispiele beschränkt. In den vorliegenden Realisierungen werden bevorzugt PIN-Dioden eingesetzt. Es können aber auch weitere bekannte Schaltelementrealisierungen wie z.B. FET-Schalter eingesetzt werden.

## Patentansprüche

1. Frequenzweiche mit einem gemeinsamen Tor (G) und einem ersten und einem zweiten Anschluss (TP, HP) und mit einem Tiefpass-Pfad (11-12-13) mit Längselementen in Serie (11,12,13) zwischen dem gemeinsamen Tor (G) und dem ersten Anschluss (TP) und einem Hochpass-Pfad (16-17-18) mit Längselementen in Serie zwischen dem gemeinsamen Tor (G) und dem zweiten Anschluss (HP), **dadurch gekennzeichnet daß** Schaltelemente (14,15,19,20) sowohl im Hochpass-Pfad (16-17-18) als auch im Tiefpass-Pfad (11-12-13) direkt von den Knoten zwischen den Längselementen nach Masse geschaltet sind und die Schaltelemente (14,15,19, 20) sowohl eine parasitäre Parallel-Kapazität (45, 48, 55, 58) als auch eine parasitäre Serien-Induktivität (46, 49, 56, 59) aufweisen, wobei sich bei aktivem Hochpass-Pfad (16-17-18) die Schaltelemente (14,15,19,20) des Hochpass-(16-17-18) und Tiefpass-Pfades (11-12-13) im durchgeschalteten Zustand befinden und wobei sich bei aktivem Tiefpass-Pfad (11-12-13) die Schaltelemente (14,15,19,20) des Hochpass-(16-17-18) und Tiefpass-Pfades (11-12-13) ausschließlich im gesperrten Zustand befinden.

2. Frequenzweiche nach Anspruch 1, **dadurch gekennzeichnet,** **dass** die parasitäre Parallel-Kapazität (45,48) der Schaltelemente (14, 15) im gesperrten Zustand als Tiefpass-Querelement verwendet wird.

3. Frequenzweiche nach Anspruch 2, **dadurch gekennzeichnet,** **dass** die im gesperrten Zustand der Schaltelemente (44, 47) als Tiefpass-Querelement verwendete parasitäre Parallel-Kapazität (45) durch eine dem Schaltelement (25) parallel geschaltete Kapazität (24) ergänzt ist.

4. Frequenzweiche nach einem der Ansprüche 1 bis 3,

**dadurch gekennzeichnet,** **dass** die parasitäre Serien-Induktivität (56,59) der Schaltelemente (54,57) im durchgeschalteten Zustand als Hochpass-Querelement (19, 20) verwendet wird.

5. Frequenzweiche nach Anspruch 4, **dadurch gekennzeichnet,** **dass** die im durchgeschalteten Zustand der Schaltelemente (34,38) als Hochpass-Querelement verwendete parasitäre Serien-Induktivität (46,49,56, 59) durch eine dem zugeordneten Schaltelement (38) in Serie geschaltete Induktivität (36) ergänzt wird.

6. Frequenzweiche nach einem der Ansprüche 1 bis 5, **dadurch gekennzeichnet,** **dass** als Schaltelemente im Tiefpass-Pfad (11-12-13) PIN-Dioden (64, 68) verwendet werden.

7. Frequenzweiche nach einem der Ansprüche 1 bis 6, **dadurch gekennzeichnet,** **dass** als Schaltelemente (19,20) im Hochpass-Pfad (16-17-18) PIN-Dioden (74,78) verwendet werden.

8. Frequenzweiche nach Anspruch 6 oder 7, **dadurch gekennzeichnet,** **dass** pro Schaltelement (44,47,54,57) mindestens zwei PIN-Dioden für einen Steuerstrom in Serie geschaltet sind, für ein Hochfrequenz-Signal jedoch unter Verwendung eines Abblockkondensators antiparallel geschaltet sind.

9. Frequenzweiche nach Anspruch 8, **dadurch gekennzeichnet,** **dass** für die Zufuhr der Steuerströme für die PIN-Dioden keine zusätzlichen Abblock-Induktivitäten im Hochpass-Pfad (71-75-79) oder Tiefpass-Pfad (61-65-69) vorhanden sind.

10. Frequenzweiche nach Anspruch 8 oder 9, **dadurch gekennzeichnet,** **dass** der Steuerstrom über denjenigen PIN-Dioden-Anschluss (U) zugeführt wird, der für das Hochfrequenz-Signal über einen Abblockkondensator (63, 67, 73,77) auf Masse liegt.

11. Frequenzweiche nach einem der Ansprüche 8, 9 oder 10, **dadurch gekennzeichnet,** **dass** über einen hochohmigen Widerstand (60, 70,80) eine Sperrspannung (Usperr) an die PIN-Dioden (64,68,74,78) gelegt ist.

12. Frequenzweiche nach einem der Ansprüche 8 oder 9, **dadurch gekennzeichnet,** **dass** der Steuerstrom der PIN-Dioden über ein Leitungspaar (U1, U2) zugeführt wird, wobei alle PIN-Dioden (82,84,87,89,93,95,99,911) über Ablockkondensatoren (83,85,88,810,94,96,910,912) nach Masse geschaltet sind, die hochohmigen Widerstände (812,92,98) nach Masse geschaltet sind und damit für ein Gleichspannungspotential von 0 Volt an den Längselementen sorgen und wobei die Sperrspannungen der PIN-Dioden über das Leitungspaar (U1, U2) anlegbar sind.

## Claims

1. Diplexer with a common gate (G) and a first and a second connection (TP, HP), and with a low pass path (11-12-13) with longitudinal elements in series (11, 12, 13) between the common gate (G) and the first connection (TP), and a high pass path (16-17-18) with longitudinal elements in series between the common gate (G) and the second connection (HP),
**characterized in that**
switching elements (14, 15, 19, 20) in both the high pass path (16-17-18) and the low pass path (11-12-13) are connected to earth directly from the nodes between the longitudinal elements, and the switching elements (14, 15, 19, 20) have both a parasitic parallel capacitor (45, 48, 55, 58) and a parasitic serial inductor (46, 49, 56, 59),
the switching elements (14, 15, 19, 20) of the high pass path (16-17-18) and low pass path (11-12-13) being in the switched-through state when the high pass path (16-17-18) is active, and
the switching elements (14, 15, 19, 20) of the high pass path (16-17-18) and low pass path (11-12-13) being exclusively in the blocked state when the low pass path (11-12-13) is active.

2. Diplexer according to Claim 1,
**characterized in that**
the parasitic parallel capacitor (45, 48) of the switching elements (14, 15) is used in the blocked state as a low pass transverse element.

3. Diplexer according to Claim 2,
**characterized in that**
the parasitic parallel capacitor (45) which is used as a low pass transverse element in the blocked state of the switching elements (44, 47) is supplemented by a capacitor (24) which is connected in parallel to the switching element (25).

4. Diplexer according to one of Claims 1 to 3,
**characterized in that**
the parasitic serial inductor (56, 59) of the switching elements (54, 57) is used in the switched-through state as a high pass transverse element (19, 20).

5. Diplexer according to Claim 4,
**characterized in that**
the parasitic serial inductor (46, 49, 56, 59) which is used in the switched-through state of the switching elements (34, 38) as a high pass transverse element is supplemented by an inductor (36) which is connected in series to the assigned switching element (38).

6. Diplexer according to one of Claims 1 to 5,
**characterized in that**
as switching elements in the low pass path (11-12-13), PIN diodes (64, 68) are used.

7. Diplexer according to one of Claims 1 to 6,
**characterized in that**
as switching elements (19, 20) in the high pass path (16-17-18), PIN diodes (74, 78) are used.

8. Diplexer according to Claim 6 or 7,
**characterized in that**
for each switching element (44, 47, 54, 57), at least two PIN diodes are connected in series for a control current, but for a high frequency signal are connected antiparallel using a blocking capacitor.

9. Diplexer according to Claim 8,
**characterized in that**
for carrying the control currents for the PIN diodes, no additional blocking inductors are present in the high pass path (71-75-79) or low pass path (61-65-69).

10. Diplexer according to Claim 8 or 9,
**characterized in that**
the control current is carried via that PIN diode connection (U) which is connected to earth via a blocking capacitor (63, 67, 73, 77) for the high frequency signal.

11. Diplexer according to one of Claims 8, 9 or 10,
**characterized in that**
a blocking voltage (Usperr) is applied to the PIN diodes (64, 68, 74, 78) via a high-resistance resistor (60, 70, 80).

12. Diplexer according to one of Claims 8 or 9,
**characterized in that**
the control current of the PIN diodes is carried via a conductor pair (U1, U2), all PIN diodes (82, 84, 87, 89, 93, 95, 99, 911) being connected to earth via blocking capacitors (83, 85, 88, 810, 94, 96, 910, 912), the high-resistance resistors (812, 92, 98) being connected to earth and thus ensuring a direct voltage potential of 0 V on the longitudinal elements, and it being possible to apply the blocking voltages of the PIN diodes via the conductor pair (U1, U2).

**Revendications**

1. Diplexeur comportant une porte commune (G) et un premier et un second raccords (TP, HP) et comportant un trajet passe-bas (11-12-13) comportant des éléments longitudinaux en série (11, 12, 13) entre la porte commune (G) et le premier raccord (TP) et un trajet passe-haut (16-17-18) comportant des éléments longitudinaux en série entre la porte commune (G) et le second raccord (HP), **caractérisé en ce que** les éléments de commutation (14, 15, 19, 20) sont commutés à la masse directement par les noeuds entre les éléments longitudinaux non seulement dans le trajet passe-haut (16-17-18) mais également dans le trajet passe-bas (11-12-13) et les éléments de commutation (14, 15, 19, 20) présentent non seulement une capacité parallèle parasite (45, 48, 55, 58) mais également une inductivité série parasite (46, 49, 56, 59),
   dans lequel les éléments de commutation (14, 15, 19, 20) du trajet passe-haut (16-17-18) et du trajet passe-bas (11-12-13) se trouvent dans l'état commuté dans le cas du trajet passe-haut actif (16-17-18) et
   dans lequel les éléments de commutation (14, 15, 19, 20) du trajet passe-haut (16-17-18) et du trajet passe-bas (11-12-13) se trouvent uniquement dans l'état coupé dans le cas d'un trajet passe-bas actif (11-12-13).

2. Diplexeur selon la revendication 1, **caractérisé en ce que** la capacité parallèle parasite (45, 48) des éléments de commutation (14, 15) est utilisée en tant qu'élément transversal passe-bas dans l'état coupé.

3. Diplexeur selon la revendication 2, **caractérisé en ce que** la capacité parallèle parasite (45) utilisée comme élément transversal passe-bas dans l'état coupé des éléments de commutation (44, 47) est complétée par une capacité (24) commutée parallèlement à l'élément de commutation (25).

4. Diplexeur selon l'une des revendications 1 à 3, **caractérisé en ce que** l'inductivité série parasite (56, 59) des éléments de commutation (54, 57) est utilisée en tant qu'élément transversal passe-haut (19, 20) dans l'état commuté.

5. Diplexeur selon la revendication 4, **caractérisé en ce que** l'inductivité série parasite (46, 49, 56, 59) utilisée en tant qu'élément transversal passe-haut dans l'état commuté des éléments de commutation (34, 38) est complétée par une inductivité commutée en série (36) à l'élément de commutation associé (38).

6. Diplexeur selon l'une des revendications 1 à 5, **caractérisé en ce que** des diodes PIN (64, 68) sont utilisées en tant qu'éléments de commutation dans le trajet passe-bas (11-12-13).

7. Diplexeur selon l'une des revendications 1 à 6, **caractérisé en ce que** des diodes PIN (74, 78) sont utilisées en tant qu'éléments de commutation (19, 20) dans le trajet passe-haut (16-17-18).

8. Diplexeur selon la revendication 6 ou 7, **caractérisé en ce que**, par élément de commutation (44, 47, 54, 57), au moins deux diodes PIN sont commutées en série pour un courant de commande, mais sont commutées antiparallèlement pour un signal haute fréquence lors de l'utilisation d'un condensateur de blocage.

9. Diplexeur selon la revendication 8, **caractérisé en ce qu'**il n'est prévu aucune inductivité de blocage supplémentaire dans le trajet passe-haut (71-75-79) ou le trajet passe-bas (61-65-69) pour les diodes PIN pour la délivrance des courants de commande.

10. Diplexeur selon la revendication 8 ou 9, **caractérisé en ce que** le courant de commande est délivré par l'intermédiaire du raccord à diodes PIN, qui se trouve à la masse par l'intermédiaire d'un condensateur de blocage (63, 67, 73, 77) pour le signal haute fréquence.

11. Diplexeur selon l'une des revendications 8, 9 ou 10, **caractérisé en ce qu'**une tension de blocage (tension U) se trouve aux diodes PIN (64, 68, 74, 78) par l'intermédiaire d'une résistance à haute impédance (60, 70, 80).

12. Diplexeur selon l'une des revendications 8 ou 9, **caractérisé en ce que** le courant de commande des diodes PIN est délivré par l'intermédiaire d'une paire de conducteurs (U1, U2), dans lequel toutes les diodes PIN (82, 84, 87, 89, 93, 95, 99, 911) sont commutées à la masse par l'intermédiaire des condensateurs de blocage (83, 85, 88, 810, 94, 96, 910, 912), les résistances à haute impédance (812, 92, 98) sont commutées à la masse et ainsi veillent à appliquer sur les éléments longitudinaux un potentiel à tension continue de 0 V et dans lequel les tensions de blocage des diodes PIN sont applicables par l'intermédiaire de la paire de conducteurs (U1, U2).

EP 1 780 889 B1

G
gemeinsames Tor

1,017nH          3,404nH          3,194nH                    0,5389pF          0,5009pF          1,678pF

    1                2                3                            6                 7                8

TP o—[====]———•——[====]———•——[====]——•———||———•———||———•———||——o HP

              1,026pF           1,484pF                        1,15nH           1,662nH

                  4                5                              9                10

                  M

Fig. 1

Frequenz (MHz)

_____△_____  DB(|S(2,1)|)
                  Diplexer_nach_Theorie

_____⋈_____  DB(|S(2,2)|)
                  Diplexer_nach_Theorie

_____☐_____  DB(|S(3,1)|)
                  Diplexer_nach_Theorie

_____  DB(|S(3,3)|)
                  Diplexer_nach_Theorie

_____◇_____  DB(|S(1,1)|)
                  Diplexer_nach_Theorie

# Fig. 2

G
gemeinsames Tor

gezeichnete Schalterstellung TP-Ein

Fig. 3

EP 1 780 889 B1

Fig. 4

Fig. 5

EP 1 780 889 B1

Fig. 6

Fig. 7

Fig. 8

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- GB 2210749 A

- US 20030022631 A1

**In der Beschreibung aufgeführte Nicht-Patentliteratur**

- **F. Methot.** Constant Impedance Bandpass and Diplexer Filters. *rf design feature,* November 1986, 92 94 96-97 99

- Design with PIN Diodes. Alpha Industries, Inc, Juni 1999, 1-18